# EUROPEAN PATENT SPECIFICATION

(11) **EP 4 456 688 B1**
(45) Date of publication and mention of the grant of the patent: **04.06.2025**
(21) Application number: 23170700.1
(22) Date of filing: 28.04.2023
(51) Int. Cl.: H05K 7/20

(54) **HEAT RECOVERY UNIT**
WÄRMERÜCKGEWINNUNGSEINHEIT
UNITÉ DE RÉCUPÉRATION DE CHALEUR

(43) Date of publication of application: 30.10.2024
(73) Proprietor: Danfoss A/S, 6430 Nordborg (DK)
(72) Inventor: HOLLNAGEL, Mikkel, 6430 Nordborg (DK)
(74) Representative: Kuhnen & Wacker Patent- und Rechtsanwaltsbüro PartG mbB

(56) References cited:
- US-A1- 2008 291 626
- US-A1- 2009 086 428
- US-A1- 2010 165 565
- US-A1- 2012 298 335

## Description

The invention pertains to a heat recovery unit suitable for use with energy recovery heat exchangers, e.g., for cooling inquiries of a data center or other installations. The invention relates also to waste heat recovery units capable to transfer waste heat to another process or location while cooling a device/installation process heat the heat recovery unit has to remove.

E.g. when operating data center a huge amount of waste heat occurs which has to be removed in an effective and economic manner. Incurring waste heat can effectively be used by transferring the heat of a coolant medium circulating within a primary circuit to a heat receiving medium circulating within a secondary circuit. Especially for use with data centers, a common technique is to install one or more containerized heat recovery units which are capable of being set up near the data center, such as outdoors, not needing any stationary buildings to be provided.

Further it is known that a containerized solution to provide a heat recovery unit is very flexible in finding an optimum between lowest capital expenditure (CAPEX) and operational expenses (OPEX) depending on the customer's needs. Due to its modular and scalable design it is easy to adapt a containerized heat recovery unit and customize its cooling power according to the requirements defined by the customer. A common type of heat exchangers to be used within a heat recovery unit of the above type is a liquid/liquid cooler of the stacked plate type, e.g. However, in principle all kinds of heat exchangers such as gas/air heat exchangers or liquid/gas heat exchangers can be used. During service life heat exchangers need maintenance such as removing fouling or replacing the gaskets fitted between the heat exchanger plates as well as repairing probable leakages that may occur.

US 2009/0086428 A1 shows a docking station for cooling an electronics rack of a data center with raised floor layout for providing a supply air plenum and space for accommodating the piping of cooling units.

Resulting from the above there is a need to provide a containerized heat recovery unit offering a minimum effort for servicing of components of the heat recovery unit such as for example maintenance of the one or more heat exchangers. Further, the costs of servicing the heat recovery unit should be minimized and the handling and accessibility of the components, especially of one or more heat exchangers should be simple.

Further it is an object of the invention to provide a heat recovery unit within a container which in total is easy to transport and to relocate.

A further object of the invention is to keep the time span needed for servicing and thus the time span within which the heat recovery unit is not operational as short as possible.

One further object of the invention is to create a design for a heat recovery unit which enables a huge amount of flexibility to adapt the cooling power of the heat recovery unit to the customer's needs by easily changing or upgrading the cooling power of the one or more heat exchangers.

In general, it is an object of the invention to provide a design for a containerized heat recovery unit providing a simple piping inside of the container and to facilitate the service of the heat exchanger preferably outside of the container without noteworthy interrupting the operation of the heat recovery unit. As a containerized heat recovery unit which have to be serviced is usually interchanged by another containerized heat recovery unit the design of at least the outer interfaces should take such a replacement can be done in short time, preferably within a few minutes.

The above objects are achieved by a heat recovery unit according to the invention defined within claim 1. Preferred embodiments are given within the subclaims.

A heat recovery unit according to the invention includes a transport container comprising at least one heat exchanger arranged in the transport container with a lower end portion or a lower end cover in case of a plate heat exchanger, facing a container floor, and an upper end portion, a upper end cover in case of a plate heat exchanger. According to the invention carrying means are arranged in a lower area of the heat exchanger enabling the insertion and extraction of the heat exchanger in a predominantly horizontal direction into and from the container in a sliding manner or in a rolling manner relative to the container. Further the lower end portion or the lower end cover in case of a plate heat exchanger have vertically upwards pointing connections for connecting the heat exchanger with the primary heat exchanging circuit and with the second heat exchanging circuit.

All the technical problems mentioned above are solved with such a heat recovery unit. Especially with the use of a heat exchanger, preferably a plate heat exchanger having end portions or end covers comprising vertically upwards pointing connections, enables a good accessibility for a service person in case that it is necessary to take out the heat exchanger for servicing or replacing the heat exchanger and/or to fix or replace any other component of the heat recovery unit. In particular the upwards pointing connections provide facilitates the release of the connections between the heat exchanger and the piping of the primary heat exchanging circuit and/or the piping of secondary heat exchanging unit. A further advantage is that all the piping connected to the heat exchanger is accessible from the above as all the connections are located on the uppermost side of the heat exchanger and therefore facing the ceiling of the container. Thus, the space in the horizontal vicinity of the heat exchanger can be freed from piping which additionally facilitates the accessibility of the components of the whole heat recovery unit for a service person who can walk and even stand in a very comfortable way during the service work, for example during the separation of the piping from the connecting points.

On the other hand the arrangement of the connections pointing vertically upwards allows to mount the heat exchanger in the heat recovery unit container in a horizontal position and not in a standing position as it known in relevant art. In the art the connections of the heat exchangers are oriented horizontal facing to inner of the container. Thereby usually two connections are on floor level of the container and the other connections in uppermost area of the heat exchanger, in many cases just below the container ceiling, which often requires a ladder to reach the bolts for connecting or disconnecting the piping. By arranging the at least one heat exchanger horizontally not only improves the accessibility to the piping connecting points since also the handling when moving the heat exchanger inside and outside of the container, because the center of gravity (CoG) of the heat exchanger is lowered leading to a higher stability during movement of the heat exchanger itself as well as when moving the heat recovery unit as a whole, i.e. during transportation of the heat recovery unit container.

Additionally to lay down the heat exchanger for an improved accessibility and handling, the provision of carrying means arranged in a lower area of the heat exchanger further facilitates the movement of the heat exchanger in the case the heat exchanger has to be taken out of the container, e.g. in case of a necessity to replace the heat exchanger with a new one, or in case of removing the heat exchanger from the container for example for servicing or replacing the pumps and/or cleaning the heat exchanger itself. With the help of the carrying means the insertion and extraction of the heat exchanger can be done easily and in a predominantly horizontal direction which enables to input and extract a heat exchanger preferably through a side wall of the container more preferable through the door side of the container. This enables the use of relatively simple transport means such as forklifts. No complicated and expensive lifting means are needed such as cranes or truck cranes lifting the heat exchanger with ropes or chains which are attached to hooks usually provided for lifting purposes at the heat exchangers known in the art. This enables a simpler design for heat exchangers which can be used in the heat recovery unit according to the invention, as theses heat exchanger do not need an additional supporting structure allowing the lifting inside the container. As a further consequence, according to the invention a plurality of heat exchanging units can be arranged in the heat recovery container in a very close manner to each other as no auxiliary means and accessibility to them is needed in order to lift a heat exchanger in the container before extracting it.

The provision of carrying means facilitates the insertion as well the extraction of a heat exchanger from the heat recovery unit container as this can be done in a rolling manner by simply pushing or pulling the heat exchanger. There is no lifting of the heat exchanger inside container needed to move the heat exchanger. This reduces the service time for a heat recovery unit significantly.

According to another embodiment of the invention the carrying means are attached to the lower end portion/cover of the heat exchanger or the heat exchanger is supported by the carrying means. Preferably the carrying means comprises rolling or sliding means which are guided in the predominantly horizontal direction by means of guiding bars mounted fixedly to the container floor.

It is preferred to attach the carrying means of the heat exchanger to a lower end portion/cover of the heat exchanger which enables a compact design. By means of the carrying and or sliding means together with the guiding bars which are fixedly mounted to the container floor a defined guidance of the movement of the heat exchanger can be achieved. Especially in case of inserting the heat exchanger into the container, guiding the sliding motion or the rolling motion simplifies the proper positioning of the heat exchanger such that the desired positions of the connecting points with respect to the piping can easily be reached. This further helps to simplify the servicing process. A further effect of this guided slidable or rollable movement of the heat exchanger is that the extraction and insertion of a heat exchanger can be achieved in an easy cartridge-like manner.

According to a further embodiment of the invention the heat exchanger and/or the carrying means are lockable to the container when the heat exchanger is at its operating position and/or when the heat recovery unit should be transported. This measurement improves the safety of transport of the containerized heat recovery unit. Further, even during normal operation of the heat recovery unit blocking the movability of the heat exchanger minimizes the shearing forces that may occur between the connections of the heat exchanger and the piping in case that the heat exchanger is moved unintended.

According to a further embodiment of the invention at least one of the upper end portion and/or the lower end portion is an upper end plate/cover and/or a lower end plate/cover. Especially in the case of using a heat exchanger of a stacked plate type it is preferable to use plates for the upper end portion and the lower end portion which offer a solid basis for attaching connections (upper plate) and/or a solid basis for attaching the carrying means (lower plate).

According to another preferable embodiment of the invention, in the operable state of the heat recovery unit, the heat exchanger is positioned next to an openable side wall of the container, e.g. adjacent to the container door(s). By doing this the insertion of the heat exchanger and its positioning to its correct location is facilitated. During the extraction of the heat exchanger from the container the necessary ranges of movement are very small.

According to the invention external ports for connecting the primary circuit and the secondary circuit to a heat source and/or heat sink are located on one or more side walls of the container, preferable on the lateral or longitudinal side walls which are not openable. This allows to easily attach the containerized heat recovery unit external piping's to the cooling /heating circuitry of, e.g., the data center. Especially if the external ports of the primary circuit and the external ports of the secondary circuit are located on opposite side walls of the container it is easy for service personal to install and establish the fluid connection to an external heat sink or source.

According to a further embodiment of the invention all components of the heat recovery unit are accommodated within the container in such a manner that the weight of the heat recovery unit is balanced with respect to a longitudinal direction L and with respect to a width direction W of the container, and, preferably, such that the center of gravity (CoG) of the heat recovery unit is located in lower vertical half of the container. These features ensure a balanced and therefore easier transport of the heat recovery unit according to the invention. Especially in case of transporting the container on a truck it is very useful to achieve the location of the center of gravity as near to the floor of the container as possible.

According to a further embodiment of the invention one or more pumps of the primary circuit and one or more pumps of the secondary circuit are accommodated in an operating area of the container. By doing this it is achieved that a modular structure of the heat recovery unit is obtained as all the main components such as pumps are concentrated within a separate area of the container. Consequently, the electrical wiring of the pumps as well as the piping to and from the pumps can be simplified.

In another implementation of the invention showing the modularity of the invention, one or n-pairs of heat exchangers are arranged in the container at the two longitudinal end regions and symmetrically to a longitudinal center, wherein the operating area for accommodating one or more pumps and/or a control unit is located in the longitudinal center area of the container. Especially in case of using pairs of heat exchangers it is preferable to locate the operating area of the container in a longitudinal center of the container and/or in the center of the container in the width direction to achieve a balanced weight distribution for a simplified transportability of the heat recovery unit according to the invention.

In a further embodiment of the invention a piping of the primary circuit and a piping of the secondary circuit each comprises a distribution line for incoming fluid and a collection line for outgoing fluid, wherein the distribution line and the collection line are located vertically above the upper end portion/cover of the at least one heat exchanger. In this context the term "located vertically above" is to be understood that the piping's are located within a region of the container that is located vertically above the upper end portions/cover of the heat exchangers. That means that the piping may be located beside and/or directly vertically above the heat exchangers, e.g. arranging the longitudinal pipes as close as possible to the upper corners or to the ceiling of the heat recovery unit container. Such an arrangement enables to provide headroom for service personal in case that they have to enter the container in order to do service work. Further with the piping vertically above the heat exchangers the fluid connection of the heat exchangers at the connections with the piping is simplified.

Preferably all connections of the heat exchanger to the primary circuit and secondary circuit are located within an area of an average standing working height of a service person. By doing so it is more comfortable for the service person to release and mount the connections in the service case of the heat exchanger(s). Further preferred, in a top view to the container floor a service area around at least two sides, preferably three or all four sides of the heat exchanger is kept free of heat recovery components. This also helps to improve the accessibility of all mountings for the service personal. Additionally the danger of unintended touching a piece of hot piping is also minimized as well as unintentional hitting components with the head.

A further embodiment of the invention shows a rolling or a sliding plane positioned on the container floor such that the carrying means can slide/roll flush onto a pallet, placeable in front of the openable side wall outside of the container for facilitating the insertion and extraction of the heat exchanger. In this way it is easy to create a plane surface for moving the heat exchanger outside the container and thus to facilitate the extraction and the insertion of such a heat exchanger. Therewith it is easy to, e.g. to disconnect the heat exchanger in the container and to push it outside onto such a plane or support without the help of lifting means and, depending on the size and weight of the heat exchanger, only by pushing manually. In the case the support or plane outside the container is a palette the heat exchanger can be transported together with the palette to another location for service or the like.

According to a further embodiment of the invention the external inlet ports and the external outlet ports of each of the primary circuit and the secondary circuit are located at least partially in the vertically lower half of the container, particularly on a vertical level of an inlet or outlet of one of the pumps. With this arrangement of the external inlet ports and the external outlet ports the internal inlets and outlets of the piping in the container can be located in the close of the operational area of the heat recovery unit in which the pumps are located. Wherein the pumps due to their weight are also located on the container floor as usually.

The heat recovery unit according to the invention is particularly suitable for use with a data center. However a heat recovery unit according to the invention can also be used with any other waste heat process to lead away heat or to provide a necessary cooling. the heat recovery unit according to the invention can also be used as mobile heating system with an integrated heat pump. A person skilled in the relevant art will find multiple usage for a heat recovery unit according to the invention which are all covered by the gist of the invention. As the heat recovery unit according to the invention comprises a primary circuit and a secondary circuit all imaginable heating and cooling systems can be equipped by the heat recovery unit according to the invention. Thereby the flexibility of adapting the cooling or heating power can easily be improved by increasing the thermal capacity of the at least one heat exchanger or by enlarging the number of containerized heat exchangers or even heat recovery units. It is not necessary to provide large stationary buildings for this purpose.

With the help of the enclosed drawings preferred embodiments of heat recovery units according to the invention are explained in more detail in order to enhance the understanding of the basic idea of the invention. The present embodiments do not limit the scope of the idea of the invention, but only represent possible design alternatives, to which within the knowledge of a person with skills in the relevant art modifications can be made without leaving the scope of the invention. Therefore, all those modifications and changes are covered by the claimed invention. In the drawings it is shown in:
- Figure 1: a schematic top view of a first embodiment of a heat recovery unit of the present invention;
- Figure 2: a schematic front view of the embodiment of Figure 1;
- Figure 3: a schematic side view of the embodiment of Figure 1;
- Figure 4: a perspective view showing schematically an embodiment for carrying means;
- Figure 5: a schematic top view of a second embodiment of a heat recovery unit of the present invention;
- Figure 6: a schematic front view of the embodiment of Figure 5;
- Figure 7: a perspective semi-transparent view of the embodiment of Figure 5;
- Figure 8: a perspective view of an embodiment according to Figure 5 or Figure 1 showing a partially removed heat exchanger.

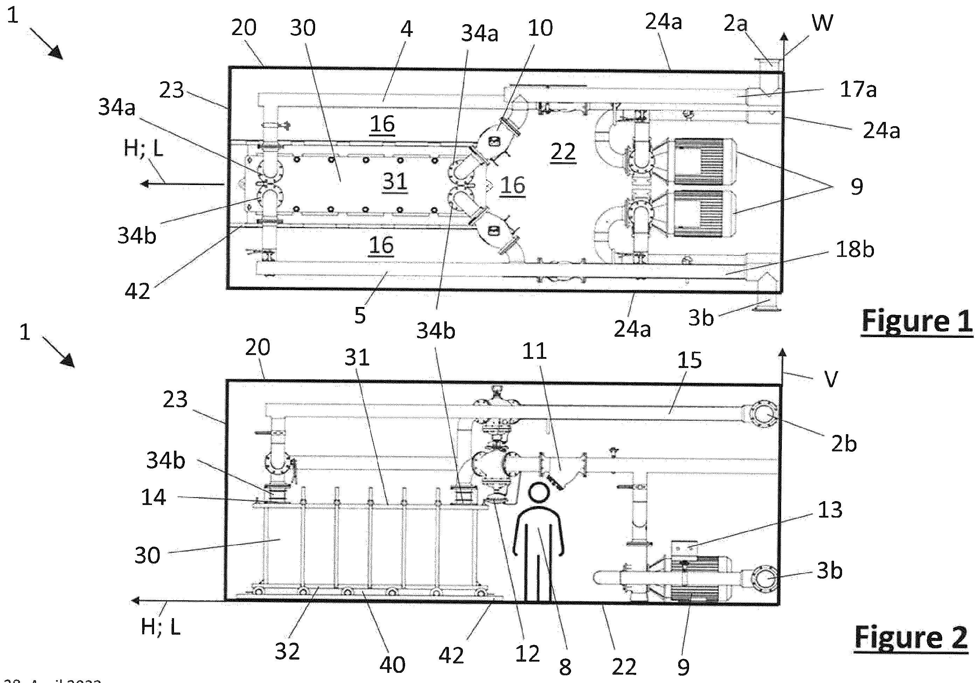

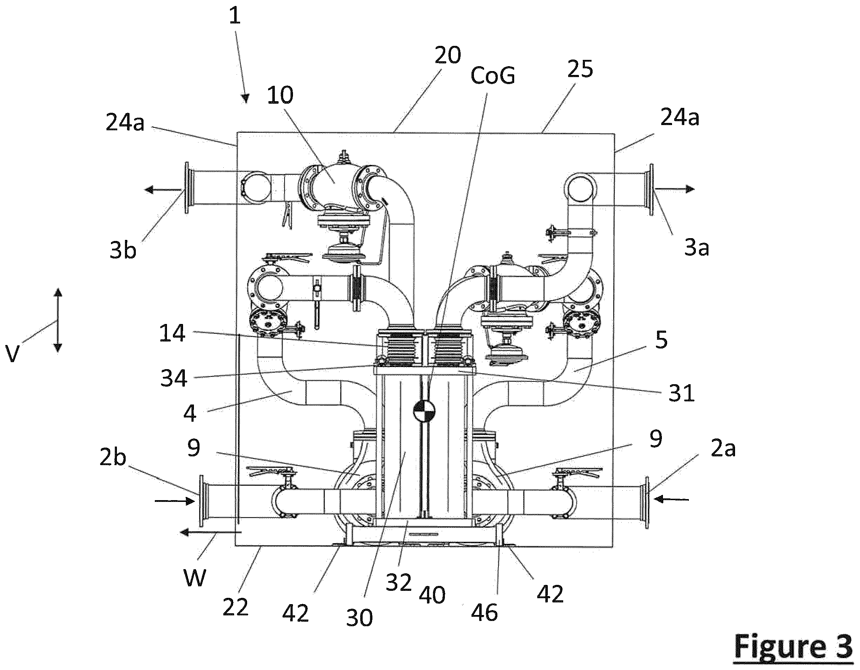

With the help of Figures 1, 2 and 3 a first embodiment of a heat recovery unit 1 according to the invention will be described. The heat recovery unit 1 includes a container 20 within which technical components of the heat recovery unit 1 such as at least one pump 9, at least one heat exchanger 30, a piping 15, at least one control valve 10, at least one stainer 11, at least one actuator 12 a at least one a control unit 13 as well as at least one compensator 14 are accommodated. Further necessary components of a heat recovery unit 1 which are neither shown nor described may be included.

In order to connect the heat recovery unit 1 to a heat source for example to a waste heat source of a data center the heat recovery unit 1 comprises an external outlet port 2a and an external inlet port 3a which belong to a primary circuit 4. The primary circuit 4 is intended to be connected to the waste heat source (not shown) for example of a data center. The waste heat may be transported by a medium entering the primary circuit 4 of the heat recovery unit 1 at the external inlet port 3a and is carried within the piping 15 of the primary circuit 4 in the form of a liquid or gaseous fluid. The piping 15 of the primary circuit 4 is connected via connecting points 34a with a respective hot end of the heat exchanger 30, wherein the piping 15 of the secondary circuit 5 is connected to the connecting point 34b. The heat exchanger 30 used in this embodiment can be a countercurrent heat exchanger or any other heat exchanger concept commonly known.

According to a particular embodiment of the invention, the heat recovery unit 1 may not comprise any fluid pumps 9. This is useful especially in case that the primary circuit 4 and the secondary circuit 5 respectively the fluids circulating therein are pumped via external pumps (not shown). In the embodiment shown the heat recovery unit according to the invention provides a passive heat recovery unit 1 in which the primary circuit 4 and the secondary circuit 5 are driven by pumps located elsewhere within the primary and secondary circuits 4 and 5. Alternatively, it is also possible that only one of the primary and secondary circuit 4 or 5 is provided with a pump 9.

In order to connect the heat recovery unit 1 to a heat sink which is intended to receive the waste heat, the heat recovery unit 1 comprises an external outlet port 2b and an external inlet port 3b which belong to a secondary circuit 5. The secondary circuit 5 is intended to be connected to the waste heat sink (not shown). The waste heat may be received by a medium carried within the piping 15 of the secondary circuit 5 in the form of a liquid fluid or gaseous fluid. The piping 15 of the secondary circuit 5 is connected via connecting points 34b with a respective cold end of the heat exchanger 30.

The heat exchanger 30 may for example be a heat exchanger of a liquid-liquid - type or of a gas-liquid- type or of a liquid-gas- type.

For the purpose of the description of the invention the primary circuit 4 is defined to carry hot medium which is to be cooled. The secondary circuit 5 is defined to carry a cold medium which is intended to receive heat from the hot medium.

Further for a better understanding of the invention illustrated in the Figures a longitudinal direction L corresponding to a horizontal direction H extending parallel to a longer sidewall 24a of the container and a with direction W extending parallel to a shorter sidewall 24b of the container as well as a vertical direction V extending vertically from a container floor 22 are indicated in Figures 1 and 2.

The container 20 may be any suitable container capable of receiving all necessary components of the heat recovery unit 1 within the internal space of the container 20. A preferable container 20 is for example a 20- foot container or a 40-foot ISO-cube or an ISO-high cube container having a standard height or an enlarged height. These containers are well known as they are widely used for example for transporting goods via container ships. The container 20 has at least one smaller sidewall 24b located next to the heat exchanger 30 which is openable and closable for example in a door like manner having door wings pivotably mounted around a vertical axis, or in a flap like manner having a flap piece being pivotably mounted around a horizontal axis with respect to the container 1.

Each of the primary circuit 4 and the secondary circuit 5 comprises a pump 9 whereas a pump inlet of the pump 9 of the primary circuit 4 is connected via the piping 15 to the external inlet port 3a of the primary circuit 4. A pump inlet of the pump 9 of the secondary circuit 5 is connected via the piping 15 to the external inlet port 3b of the secondary circuit 5.

A pump outlet of the pump 9 of the primary circuit 4 is connected via the piping 15 to an inlet connecting point 34a of the hot end of the heat exchanger 30. The outlet connecting point 34a of the heat exchanger 1 is connected to the external outlet port 2a of the primary circuit 4.

A pump outlet of the pump 9 of the secondary circuit 5 is connected via the piping 15 to an inlet connecting point 34a of the cold end of the heat exchanger 30. The outlet connecting point 34a of the heat exchanger 30 is connected to the external outlet port 2b of the secondary circuit 5.

The heat exchanger 30 of this embodiment is a heat exchanger 30 of the stacked plate type having an upper portion 31 facing a ceiling 25 of the container 20 and having a lower portion 32 facing the container floor 22. All the connecting points 34a and34b are located on the upper portion 31 of the heat exchanger 30 and are also facing the ceiling 25. The upper portion 31 of the heat exchanger 30 is formed by an upper plate 36. The lower portion 32 of the heat exchanger 30 is formed by a lower plate 37. The upper plate 36 together with the lower plate 37 and several studs 38 are forming a frame for the heat exchanger 30 whereas heat exchanging plates of the stacked plate type heat exchanger 30 are located between the upper plate 36 and the lower plate 37. The heat exchanging plates are fixed in a sealed manner between the upper plate 36 and the lower plate 37.

The pumps 9 are concentrated within a pump area 9a which in the embodiment of Figures 1 to 3, is located in the vicinity of one of the two shorter sidewalls 24b. A space in the vicinity of the heat exchanger 30 is kept free of components and devices such that an operating area 16 on the container floor 22 is formed on which service personal 8 can move around the heat exchanger 30 and perform maintenance and service work needed without being boxed in a tight working space.

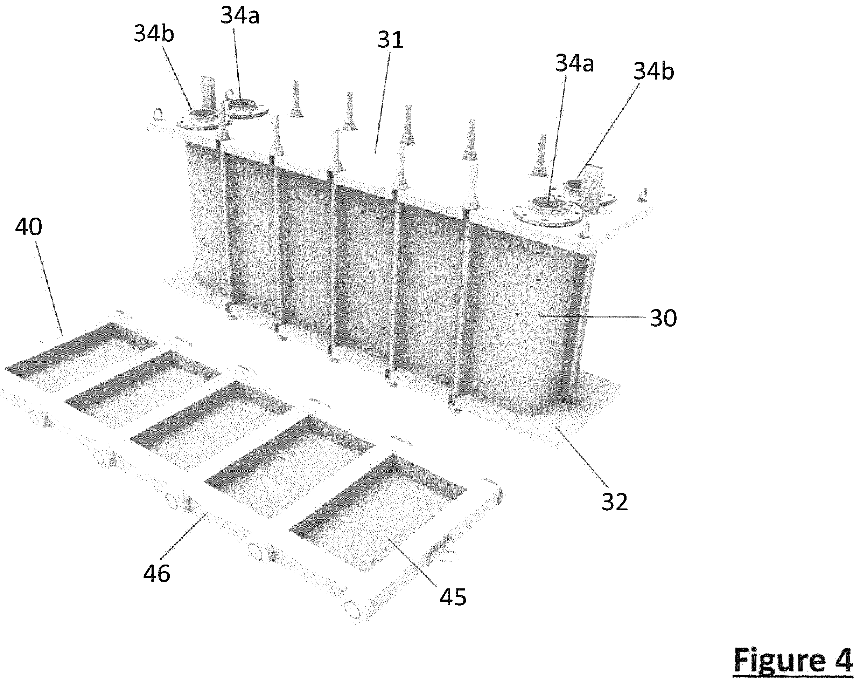

The heat exchanger 30 is provided with carrying means 40 having rolling/sliding means 41. Within the embodiment of Figures 1 to 3 the rolling/sliding means 41 are formed as wheels. The rolling/sliding means 41 particularly the wheels may be directly attached to the lower plate 37 of the heat exchanger 30. A further alternative design is to provide a rolling/sliding carriage 46 comprising the rolling/sliding means 41 for example the wheels (see also Figure 4). The rolling/sliding carriage 46 is supposed to support the heat exchanger 30. According to a further embodiment it may be useful to further provide fixing means (not shown) for fixing the at least one heat exchanger 30 or the carrying means 40 along a sliding/rolling direction.

The rolling/sliding means 4 1 and/or the rolling/sliding carriage 46 are guided by guiding bars 42 mounted on a rolling/sliding plane 43. The rolling/sliding plane 43 may be the container floor 22 or slightly elevated plane such as an elevated platform.

The rolling/sliding means 41 of the carrying means 40 allow a basically horizontal movement along a horizontal direction 7. Preferably the horizontal movement of the heat exchanger 30 is in parallel to the longitudinal direction L.

In the embodiment of Figures 1 to 3 all piping 15 reaching and leaving the heat exchanger 30 is arranged vertically above the upper portion 31 of the heat exchanger 30. This ensures that the space in the vicinity of the heat exchanger 30, in particular below the connecting points 34a and 34b is kept free of disturbing piping and a service person 8 can perform the maintenance work in a (comfortable) manner.

The connecting points 34a and 34b are preferably formed by compensators 14 being intended to compensate probable linear or angular misalignments of the heat exchanger connecting points 34a and 34b with respect to the piping. In order to achieve such a compensation the compensators 14 may be corrugated tubes or similar compensating devices capable of compensating positional and/or angular misplacements.

According to a preferred embodiment of the invention the rolling/sliding carriage 46 includes a drain pan 45 (see Figure 4) capable of collecting leakage fluid which may occur if the heat exchanger 30, and particular its connection points 34a and 34b to the piping 15 are released. This helps to maintain the container floor 22 clean and avoids environmental contamination.

A particular advantage of the invention is a low center of gravity (CoG) which facilitates the transport of the heat recovery unit especially when craning and lifting the heat recovery unit. This advantage is particularly achieved by arranging the heat exchanger 30 with its connecting points 34a and 34b facing vertically upwards to the ceiling 25 of the container 20. Further the balancing of the container is improved when the heat exchanger 30 is positioned along a centerline which corresponds to the centerline in the width direction W. By positioning the heat exchanger according to the above described manner, it is particularly easy to arrange most of the piping 15 on the ceiling level above the upper portion 31 of the heat exchanger.

The horizontal oriented heat exchanger allows a low center of gravity CoG of the heat recovery unit 1 and at the same time provides enough space for the operating area 16 in order to provide a comfortable working space for a service person 8. Additionally, an easy servicing and maintenance access is achieved by the cartridge like changeability of the heat exchanger 30 with the help of the carrying means 40 in the horizontal direction H or at least in a predominantly horizontal direction H.

The predominantly horizontal direction H is defined as being a vector direction having a horizontal vector component of a larger magnitude compared to a vertical vector component. In other words, the predominantly horizontal direction H in the sense of the invention also includes inclined rolling/sliding planes 43 inclined with respect to the exact horizontal direction H. A ramp-like design of the rolling/sliding plane 43 helps to insert and extract the heat exchanger 30 into and from the container 20 along a downward slope.

The rolling/sliding plane 43 may be part of the openable sidewall 23 which facilitates the extraction/insertion of the heat exchanger 31. Especially with a flap design of the open side 23 of the container 20 a ramp functionality can be achieved to facilitate insertion and extraction of the heat exchanger 30 without overcoming a step formed by the container floor 22, e.g.

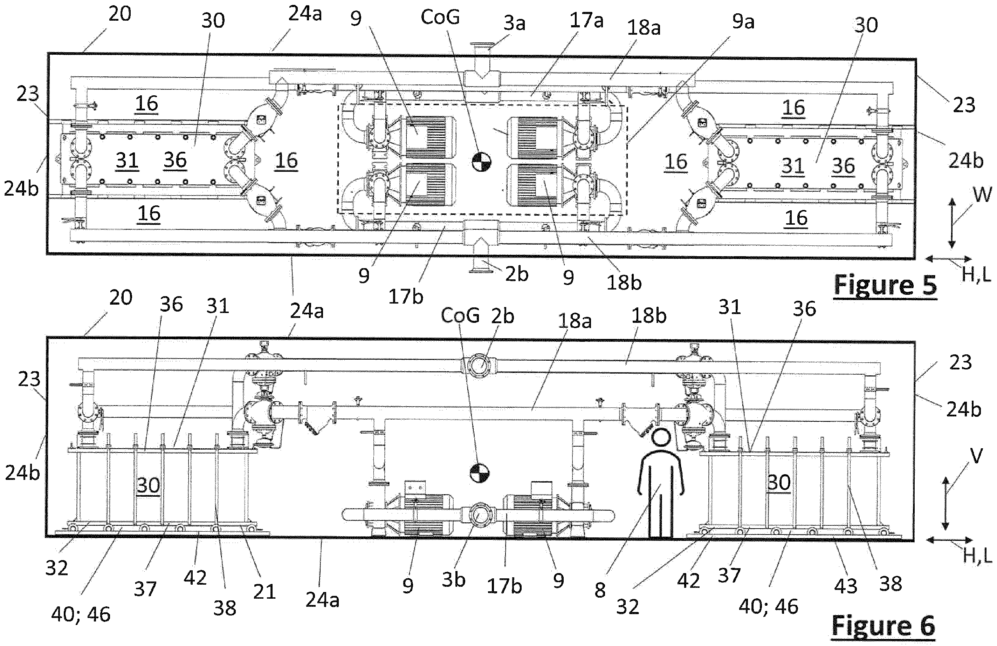

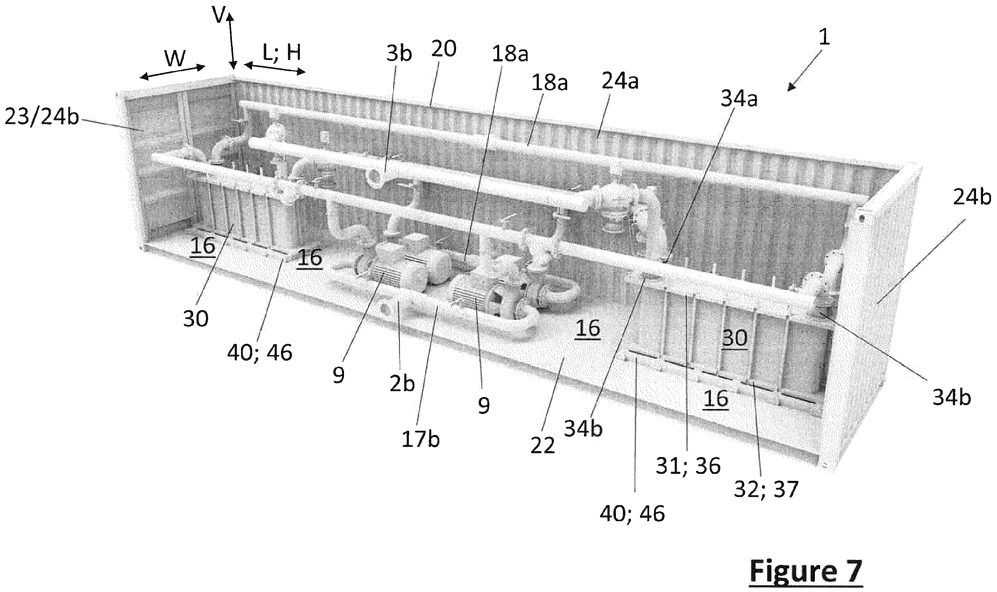

With respect to Figures 5 to 7 a second embodiment of the heat recovery unit 1 of the invention is described. The second embodiment of the heat recovery unit largely corresponds to the first embodiment of the heat recovery unit such that equal or similar components are denoted with the help of same reference numerals. The main difference between the first and second embodiment is that the second embodiment according to Figure 5 to 8 merely is a mirrored doubled version of the embodiment according to Figures 1 to 3. In addition to the first set of pumps 9 described in accordance with the first embodiment the second embodiment is provided with a second set of pumps 9 in direct vicinity of the first set of pumps 9. The primary circuits 4 of the mirrored heat recovery units 1 are connected via an inlet distribution line 17a and an outlet collection line 18a to the non-mirrored primary circuit 4 to form one common primary circuit 4. An analogous is valid for the secondary circuit 5 of the mirrored heat recovery units 1.

Next to both shorter sidewalls 24b, which both are designed to be openable sidewalls 23, a heat exchanger 30 is located respectively. Each heat exchanger 30 is a heat exchanger of the stacked plate type as described above and is also supported by the carrying means 40 as described above in connection with the first embodiment. As a consequence, each heat exchanger 30 is slidable along the horizontal direction H in a guided manner by the carrying means 40 and the guiding bars 42. The pump area 9a is located in a center with respect to the longitudinal direction L whereas in the vicinity of both heat exchangers 30 an obstacle free operating area 16 can be provided. The symmetrical design of the embodiment according to Figures 5 to 7 with respect to the longitudinal direction L results in a central location of the center of gravity (CoG) with respect to the longitudinal direction L. This facilitates transporting and/or lifting of the containerized heat recovery unit 1 as it is balanced along the longitudinal direction L. The balance with respect to the width direction W is achieved by the same measurements as pre-described with respect to the first embodiment according to Figures 1 to 3. For example, the heat exchangers 30 are located in the center of the two longer side wall 24a, i.e. with respect to the width direction W, as well as the pumps 9 being arranged also in a symmetrical manner with respect to the width direction W.

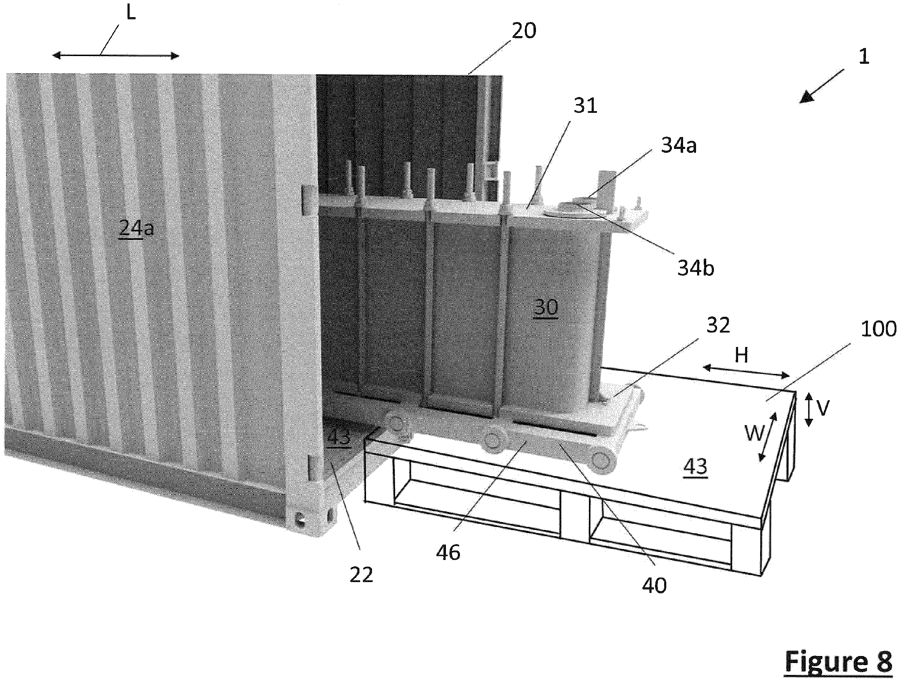

Figure 8 shows a situation during an insertion or extraction phase of the heat exchanger in which the heat exchanger 30 is removed from or installed to the heat recovery unit 1 of the invention. The heat exchanger 30 is already from or not yet connected to the piping 15. In order to extract or insert the heat exchanger 30 it is preferred to position a palette 100 next to the open side of the container 20, wherein an upper side of the palette 100 is positioned such that it is flush with the rolling/sliding plane 43 which may be the container floor 22. When having the heat exchanger 30 positioned on the pallet 100 completely the heat exchanger 30 can be handled together with the palette 100 for example by the help of a forklift in a comfortable and easy manner. It may occur that leakage fluid exits the heat exchanger 30. For this the rolling/sliding carriage 46 can be equipped with a drain pan 45 which collects the leakage fluid and thus avoids contamination of the environment.

In summary the heat recovery unit 1 of the invention offers the following advantages with respect to heat recovery units of the prior art:
- easy and comfortable maintenance;
- easily scalable due to a modular design;
- cost-effective with respect to capital expenditure and operational expenses;
- low shutdown time of the heat recovery unit caused by maintenance;
- cartridge like exchangeability of the heat exchangers;
- easy handling and transporting of the heat recovery unit due to the lower and balanced center of gravity
- minimized effort for mounting and dismounting the heat exchanger due to the vertically upwards pointing connecting points
- frame parts for fixing the heat exchanger within the container can be omitted;
- easy removal of the heat exchanger from the container to a palette via a ratchet pulley, e.g.;
- simplified transportation of the heat exchanger together with the palette, for example by the help of a forklift;
- compact design while providing more working space for a service person as with prior art solutions.

Finally, it should be noted that the present embodiments show concepts of the present invention. Definitions of shapes, forms, connections, or numbers are only exemplary and may vary for different applications. However, all modifications within the knowledge of a person skilled in the relevant art are covered as long as said modifications fall within the scope of the invention, which is defined by the appended claims.

### Reference List

| | | | |
|---|---|---|---|
| 1 | Heat recovery unit | 24b | Shorter side wall |
| 2a | External inlet port | 25 | Ceiling (container) |
| 2b | External inlet port | | |
| 3a | External outlet port | 30 | Heat exchanger |
| 3b | External outlet port | 31 | Upper portion |
| 4 | Primary circuit | 32 | Lower portion |
| 5 | Secondary circuit | 34a | Connecting points |
| | | 34b | Connecting points |
| 8 | Service person | 36 | Upper plate |
| | | 37 | Lower plate |
| 9 | Pump | 38 | Studs |
| 9a | Pump area | | |
| 10 | Control valve | 40 | Carrying means |
| 11 | Stainer | 41 | Rolling/Sliding means |
| 12 | Actuator | 42 | Guiding bars |
| 13 | Control unit | 43 | Rolling/Sliding plane |
| 14 | Compensator | 45 | Drain pan |
| 15 | Piping | 46 | Rolling/sliding carriage |
| 16 | Operating area | | |
| 17a | Inlet distribution line | 100 | Palette |
| 17b | Inlet distribution line | | |
| 18a | Outlet collection line | L | Longitudinal direction |
| 18b | Outlet collection line | W | Width direction |
| | | H | (predominantly) horizontal |
| 20 | Container | | direction |
| 21 | Underside | V | vertical direction |
| 22 | Container floor | | |
| 23 | Openable side wall | | |
| 24a | Longer side wall | | |

## Claims

1. Heat recovery unit (1) including a transport container (20) comprising at least one heat exchanger (30) arranged in the transport container (20), with a lower end portion (32) facing a container floor (22), and an upper end portion (31), wherein the heat exchanger (30) is configured to exchange heat between a medium carried within a primary circuit (4) and a medium carried within a secondary circuit (5), and wherein carrying means (40) are arranged in a lower area of the heat exchanger (30) enabling the insertion and extraction of the heat exchanger (30) in a predominantly horizontal direction (7) into and from the container (20) in a sliding manner or in a rolling manner relative to the container (20),
**characterized in that**
external ports (2; 3) of the primary circuit (4) and the secondary circuit (5) are located on one or more side walls (24) of the transport container (20);
the piping (15) of the primary circuit (4) and the piping (15) of the secondary circuit (5) are provided inside of the transport container (20);
all piping (15) reaching and leaving the heat exchanger (30) is arranged vertically above the upper portion (31) of the heat exchanger (30); and **in that**
the upper end portion (31) has vertically upwards pointing connecting points (34, 35) for connecting the heat exchanger (30) with the primary circuit (4) and with the secondary circuit (5)

2. Heat recovery unit (1) according to claim 1, wherein the carrying means (40) are attached to the lower end portion (32) or the heat exchanger (30) is supported by the carrying means (40), and wherein the carrying means (40) comprises rolling or sliding means (41) which are guided in the predominantly horizontal direction (7) by means of guiding bars (42) mounted fixedly to the container floor (22).

3. Heat recovery unit (1) according to claim 1 or 2, wherein the heat exchanger (30) and/or the carrying means (40) are lockable to the container (20) when the heat exchanger (30) is at its operating position and/or when the heat recovery unit (1) should be transported.

4. Heat recovery unit (1) according to one of the preceding claims, wherein at least one of the upper end portion (31) and/or the lower end portion (32) is an upper end plate and/or a lower end plate.

5. Heat recovery unit (1) according to one of the preceding claims, wherein, in the operable state of the heat recovery unit (1), the heat exchanger (30) is positioned next to an openable side wall (23) of the container (20).

6. Heat recovery unit (1) according to one of the preceding claims, wherein all components of the heat recovery unit (1) are accommodated within the container (20) such that the weight of the heat recovery unit (1) is balanced with respect to a longitudinal direction (L) and with respect to a width direction (W) of the container (20), and such that the centre of gravity (CoG) of the heat recovery unit (1) is located in lower vertical half of the container (20).

7. Heat recovery unit (1) according to one of the preceding claims, wherein one or more pumps (9) of the primary circuit (4) and one or more pumps (9) of the secondary circuit (5) are accommodated in an operating area (16) of the container (20).

8. Heat recovery unit (1) according to one of the preceding claims, wherein one or n-pairs of heat exchangers (30) are arranged in the container (20) at longitudinal end regions symmetrically to a longitudinal centre, wherein the operating area (16) for accommodating one or more pumps and/or a control unit (13) is located in the longitudinal centre area of the container (20).

9. Heat recovery unit (1) according to one of the preceding claims, wherein a piping (15) of the primary circuit (4) and a piping (15) of the secondary circuit (5) each comprises a distribution line (17) for incoming fluid and a collection line (18) for outgoing fluid, wherein the distribution line (17) and the collection line (18) are located vertically above the upper end portion (31) of the at least one heat exchanger (30).

10. Heat recovery unit (1) according to one of the preceding claims, wherein all connecting points (34; 35) of the heat exchanger (30) to the primary circuit (4) and secondary circuit (5) are located within an area of an average standing working height of a service person.

11. Heat recovery unit (1) according to one of the preceding claims, wherein in a top view a service area on the container floor (22) around at least two sides of the heat exchanger (30) is kept free of heat recovery components.

12. Heat recovery unit (1) according to one of the preceding claims, wherein a rolling or a sliding plane (43) is provided on the container floor (22) such that the carrying means (40) can slide/roll flush onto a pallet (100) placeable in front of the openable side wall (23) outside of the container (20) for insertion and extraction of the heat exchanger (30).

13. Heat recovery unit (1) according to anyone of claims 5 to 12, wherein the external inlet ports (2) and the external outlet ports (3) of each of the primary circuit (4) and the secondary circuit (5) are located at least partially in the vertically lower half of the container (20).

14. Heat recovery unit (1) according to one of the preceding claims for use with a data centre.

## Patentansprüche

1. Wärmerückgewinnungseinheit (1), die einen Transportcontainer (20) aufweist, der zumindest einen Wärmetauscher (30) aufweist, der in dem Transportcontainer (20) angeordnet ist, mit einem unteren Endabschnitt (32), der einem Containerboden (22) zugewandt ist, und einem oberen Endabschnitt (31), wobei der Wärmetauscher (30) ausgebildet ist, um Wärme zwischen einem in einem Primärkreislauf (4) geführten Medium und einem in einem Sekundärkreislauf (5) geführten Medium auszutauschen, und wobei in einem unteren Bereich des Wärmetauschers (30) Tragmittel (40) angeordnet sind, die das Einsetzen und Herausziehen des Wärmetauschers (30) in einer überwiegend horizontalen Richtung (7) in den und aus dem Behälter (20) auf gleitende oder rollende Weise relativ zum Behälter (20) ermöglichen,
**dadurch gekennzeichnet, dass**
- die externen Anschlüsse (2; 3) des Primärkreislaufs (4) und des Sekundärkreislaufs (5) an einer oder mehreren Seitenwänden (24) des Transportbehälters (20) angeordnet sind;
- die Rohrleitungen (15) des Primärkreislaufs (4) und die Rohrleitungen (15) des Sekundärkreislaufs (5) innerhalb des Transportbehälters (20) angeordnet sind;
- alle Rohrleitungen (15), die zum Wärmetauscher (30) führen und ihn verlassen, vertikal oberhalb des oberen Abschnitts (31) des Wärmetauschers (30) angeordnet sind; und dass
- der obere Abschnitt (31) vertikal nach oben weisende Anschlussstellen (34, 35) aufweist, um den Wärmetauscher (30) mit dem Primärkreislauf (4) und mit dem Sekundärkreislauf (5) zu verbinden

2. Wärmerückgewinnungseinheit (1) nach Anspruch 1, wobei die Tragmittel (40) am unteren Endabschnitt (32) angebracht sind oder der Wärmetauscher (30) von den Tragmitteln (40) abgestützt wird, und wobei die Tragmittel (40) Roll- oder Gleitmittel (41) aufweisen, die mittels fest am Containerboden (22) montierter Führungsstangen (42) in der überwiegend horizontalen Richtung (7) geführt werden.

3. Wärmerückgewinnungseinheit (1) nach Anspruch 1 oder 2, wobei der Wärmetauscher (30) und/oder das Tragmittel (40) an dem Container (20) verriegelbar sind, wenn sich der Wärmetauscher (30) in seiner Betriebsposition befindet und/oder wenn die Wärmerückgewinnungseinheit (1) transportiert werden soll.

4. Wärmerückgewinnungseinheit (1) nach einem der vorhergehenden Ansprüche, wobei zumindest einer der oberen Endabschnitte (31) und/oder der unteren Endabschnitte (32) eine obere Endplatte und/oder eine untere Endplatte ist.

5. Wärmerückgewinnungseinheit (1) nach einem der vorhergehenden Ansprüche, wobei im betriebsbereiten Zustand der Wärmerückgewinnungseinheit (1) der Wärmetauscher (30) neben einer öffenbaren Seitenwand (23) des Containers (20) angeordnet ist.

6. Wärmerückgewinnungseinheit (1) nach einem der vorhergehenden Ansprüche, wobei alle Komponenten der Wärmerückgewinnungseinheit (1) derart in dem Container (20) untergebracht sind, dass das Gewicht der Wärmerückgewinnungseinheit (1) in Bezug auf eine Längsrichtung (L) und in Bezug auf eine Breitenrichtung (W) des Containers (20) ausgeglichen ist, und derart, dass der Schwerpunkt (CoG) der Wärmerückgewinnungseinheit (1) in der unteren vertikalen Hälfte des Containers (20) angeordnet ist.

7. Wärmerückgewinnungsanlage (1) nach einem der vorhergehenden Ansprüche, wobei eine oder mehrere Pumpen (9) des Primärkreislaufs (4) und eine oder mehrere Pumpen (9) des Sekundärkreislaufs (5) in einem Betriebsbereich (16) des Containers (20) aufgenommen sind.

8. Wärmerückgewinnungsanlage (1) nach einem der vorhergehenden Ansprüche, wobei im Container (20) ein oder n-Paare von Wärmetauschern (30) an längsseitigen Endbereichen symmetrisch zu einer Längsmitte angeordnet sind, wobei im längsseitigen Mittelbereich des Containers (20) der Betriebsbereich (16) zur Aufnahme einer oder mehrerer Pumpen und/oder einer Steuereinheit (13) angeordnet ist.

9. Wärmerückgewinnungseinheit (1) nach einem der vorhergehenden Ansprüche, wobei eine Rohrleitung (15) des Primärkreislaufs (4) und eine Rohrleitung (15) des Sekundärkreislaufs (5) jeweils eine Verteilleitung (17) für ankommendes Fluid und eine Sammelleitung (18) für abgehendes Fluid aufweist, wobei die Verteilleitung (17) und die Sammelleitung (18) vertikal über dem oberen Endabschnitt (31) des mindestens einen Wärmetauschers (30) angeordnet sind.

10. Wärmerückgewinnungsanlage (1) nach einem der vorhergehenden Ansprüche, wobei alle Anschlussstellen (34; 35) des Wärmetauschers (30) an den Primärkreislauf (4) und den Sekundärkreislauf (5) in einem Bereich angeordnet sind, der der durchschnittlichen Stehhöhe einer Serviceperson entspricht.

11. Wärmerückgewinnungseinheit (1) nach einem der vorhergehenden Ansprüche, wobei in der Draufsicht auf dem Containerboden (22) ein Wartungsbereich an zumindest zwei Seiten des Wärmetauschers (30) von Komponenten der Wärmerückgewinnung freigehalten wird.

12. Wärmerückgewinnungseinheit (1) nach einem der vorhergehenden Ansprüche, wobei auf dem Containerboden (22) eine Roll- oder Gleitebene (43) derart vorgesehen ist, dass das Tragmittel (40) zum Einsetzen und Entnehmen des Wärmetauschers (30) bündig auf eine vor der zu öffnenden Seitenwand (23) außerhalb des Containers (20) aufstellbare Palette (100) gleiten/rollen kann.

13. Wärmerückgewinnungseinheit (1) nach einem der Ansprüche 5 bis 12, wobei die externen Einlassanschlüsse (2) und die externen Auslassanschlüsse (3) sowohl des Primärkreislaufs (4) als auch des Sekundärkreislaufs (5) zumindest teilweise in der vertikal unteren Hälfte des Containers (20) angeordnet sind.

14. Wärmerückgewinnungseinheit (1) nach einem der vorhergehenden Ansprüche zur Verwendung in einem Datenzentrum.

## Revendications

1. Unité de récupération de chaleur (1) incluant un conteneur de transport (20) comprenant au moins un échangeur de chaleur (30) disposé dans le conteneur de transport (20), avec une partie d'extrémité inférieure (32) faisant face à un plancher de conteneur (22), et une partie d'extrémité supérieure (31), dans laquelle l'échangeur de chaleur (30) est configuré pour échanger de la chaleur entre un fluide transporté dans un circuit primaire (4) et un fluide transporté dans un circuit secondaire (5), et dans lequel des moyens de transport (40) sont disposés dans une zone inférieure de l'échangeur de chaleur (30) permettant l'insertion et l'extraction de l'échangeur de chaleur (30) dans une direction principalement horizontale (7) dans et hors du conteneur (20) par glissement ou par roulement par rapport au conteneur (20),
**caractérisée en ce que**
les orifices externes (2; 3) du circuit primaire (4) et du circuit secondaire (5) sont situés sur une ou plusieurs parois latérales (24) du conteneur de transport (20) ;
la tuyauterie (15) du circuit primaire (4) et la tuyauterie (15) du circuit secondaire (5) sont placées à l'intérieur du conteneur de transport (20) ;
toute la tuyauterie (15) arrivant à l'échangeur de chaleur (30) et en sortant est disposée verticalement au-dessus de la partie supérieure (31) de l'échangeur de chaleur (30) ; et **en ce que**
la partie d'extrémité supérieure (31) comporte des points de raccordement (34, 35) orientés verticalement vers le haut et destinés à raccorder l'échangeur de chaleur (30) au circuit primaire (4) et au circuit secondaire (5)

2. Unité de récupération de chaleur (1) selon la revendication 1, dans laquelle les moyens de transport (40) sont fixés à la partie d'extrémité inférieure (32) ou l'échangeur de chaleur (30) est supporté par les moyens de transport (40) et dans laquelle les moyens de transport (40) comprennent des moyens de roulement ou de glissement (41) qui sont guidés dans la direction principalement horizontale (7) au moyen de barres de guidage (42) montées de manière fixe sur le plancher du conteneur (22).

3. Unité de récupération de chaleur (1) selon la revendication 1 ou 2, dans laquelle l'échangeur de chaleur (30) et/ou les moyens de transport (40) peuvent être verrouillés au conteneur (20) lorsque l'échangeur de chaleur (30) est en position de fonctionnement et/ou lorsque l'unité de récupération de chaleur (1) doit être transportée.

4. Unité de récupération de chaleur (1) selon l'une des revendications précédentes, dans laquelle au moins l'une des parties d'extrémité supérieure (31) et/ou d'extrémité inférieure (32) est une plaque d'extrémité supérieure et/ou une plaque d'extrémité inférieure.

5. Unité de récupération de chaleur (1) selon l'une des revendications précédentes, dans laquelle, en état de fonctionnement de l'unité de récupération de chaleur (1), l'échangeur de chaleur (30) est positionné à côté d'une paroi latérale ouvrable (23) du conteneur (20).

6. Unité de récupération de chaleur (1) selon l'une des revendications précédentes, dans laquelle tous les composants de l'unité de récupération de chaleur (1) sont logés dans le conteneur (20) de telle sorte que le poids de l'unité de récupération de chaleur (1) est équilibré par rapport à une direction longitudinale (L) et par rapport à une direction de largeur (W) du conteneur (20) et de telle sorte que le centre de gravité (CoG) de l'unité de récupération de chaleur (1) est situé dans la moitié verticale inférieure du conteneur (20).

7. Unité de récupération de chaleur (1) selon l'une des revendications précédentes, dans laquelle une ou plusieurs pompes (9) du circuit primaire (4) et une ou plusieurs pompes (9) du circuit secondaire (5) sont logées dans une zone de fonctionnement (16) du conteneur (20).

8. Unité de récupération de chaleur (1) selon l'une des revendications précédentes, dans laquelle un ou n paires d'échangeurs de chaleur (30) sont disposées dans le conteneur (20) à des régions d'extrémité longitudinales symétriques par rapport à un centre longitudinal, dans laquelle la zone de fonctionnement (16) destinée à recevoir une ou plusieurs pompes et/ou une unité de commande (13) est située dans la zone centrale longitudinale du conteneur (20).

9. Unité de récupération de chaleur (1) selon l'une des revendications précédentes, dans laquelle une tuyauterie (15) du circuit primaire (4) et une tuyauterie (15) du circuit secondaire (5) comprennent chacune une conduite de distribution (17) pour le fluide entrant et une conduite de collecte (18) pour le fluide sortant, la conduite de distribution (17) et la conduite de collecte (18) étant situées verticalement au-dessus de la partie d'extrémité supérieure (31) de l'au moins un échangeur de chaleur (30).

10. Unité de récupération de chaleur (1) selon l'une des revendications précédentes, dans laquelle tous les points de raccordement (34 ; 35) de l'échangeur de chaleur (30) au circuit primaire (4) et au circuit secondaire (5) sont situés dans une zone de hauteur moyenne de travail debout d'un agent de service.

11. Unité de récupération de chaleur (1) selon l'une des revendications précédentes, dans laquelle, en vue de dessus, une zone de service sur le plancher du conteneur (22) autour d'au moins deux côtés de l'échangeur de chaleur (30) est dépourvue de composants de récupération de chaleur.

12. Unité de récupération de chaleur (1) selon l'une des revendications précédentes, dans laquelle un plan de roulement ou de glissement (43) est prévu sur le plancher du conteneur (22) de telle sorte que les moyens de transport (40) puissent glisser/rouler à plat sur une palette (100) placée devant la paroi latérale ouvrable (23) à l'extérieur du conteneur (20) pour l'insertion et l'extraction de l'échangeur de chaleur (30).

13. Unité de récupération de chaleur (1) selon l'une des revendications 5 à 12, dans laquelle les orifices d'entrée externes (2) et les orifices de sortie externes (3) de chacun des circuits primaire (4) et secondaire (5) sont situés au moins en partie dans la moitié inférieure verticale du conteneur (20).

14. Unité de récupération de chaleur (1) selon l'une des revendications précédentes, destinée à être utilisée avec un centre de données.
